# EUROPEAN PATENT SPECIFICATION

(11) **EP 3 996 473 B1**
(45) Date of publication and mention of the grant of the patent: **30.04.2025**
(21) Application number: 20205934.1
(22) Date of filing: 05.11.2020
(51) Int. Cl.: H05K 1/02, H05K 1/18, H05K 3/42, H05K 3/46

(54) **COMPONENT CARRIER WITH ELECTRONIC COMPONENTS AND THERMALLY CONDUCTIVE BLOCKS ON BOTH SIDES**
KOMPONENTENTRÄGER MIT ELEKTRONISCHEN KOMPONENTEN UND THERMISCH LEITFÄHIGEN BLÖCKEN AUF BEIDEN SEITEN
SUPPORT DE COMPOSANT À COMPOSANTS ÉLECTRONIQUES ET BLOCS THERMIQUEMENT CONDUCTEURS DES DEUX CÔTÉS

(43) Date of publication of application: 11.05.2022
(60) Divisional application: 25159564.1
(73) Proprietor: AT & S Austria Technologie & Systemtechnik Aktiengesellschaft, 8700 Leoben-Hinterberg (AT)
(72) Inventor: Morianz, Mike, 8045 Graz (AT); Stahr, Johannes, 8605 St. Lorenzen im Mürztal (AT); Pressler, Simon, 8020 Graz (AT); Prutti, Maria, 8600 Bruck an der Mur (AT)
(74) Representative: Dilg, Haeusler, Schindelmann Patentanwaltsgesellschaft mbH

(56) References cited:
- EP-A1- 3 716 321
- US-A1- 2008 041 619
- US-A1- 2016 050 768
- US-A1- 2016 079 156
- US-B2- 10 143 092

## Description

The invention relates to methods of manufacturing a component carrier, and to component carriers.

In the context of growing product functionalities of component carriers equipped with one or more electronic components and increasing miniaturization of such components as well as a rising number of components to be mounted on or embedded in the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions. Prior art document EP3716321A of Austria Tech & System Tech discloses a component carrier comprising a stack which comprises at least one electrically conductive layer structure and/or at least one electrically insulating layer structure , a semiconductor component embedded in the stack, and a highly conductive block embedded in the stack and being thermally and/or electrically coupled with the semiconductor component.

In particular, efficiently removing heat from an embedded electronic component in a component carrier is an issue.

There may be a need to efficiently remove heat from an electronic component in a component carrier.

An embodiment is defined by claim 1 and a corresponding method of manufacturing by claim 12.

According to an aspect of the invention, a component carrier is provided which comprises a stack comprising at least one electrically conductive layer structure and at least one electrically insulating layer structure, a thermally conductive and electrically conductive block arranged in the stack, a vertical hole extending through at least part of the stack and through the entire block, wherein the block has a nail head structure surrounding at least part of the vertical hole and protruding downwardly beyond a planar portion of a lower main surface of the block and protruding upwardly beyond a planar portion of an upper main surface of the block, and a contact structure (in particular an electrically conductive contact structure) in at least part of the vertical hole establishing a connection (in particular an electrically conductive connection) with the block along the nail head section.

According to another aspect of the invention, a method of manufacturing a component carrier is provided, wherein the method comprises providing a stack comprising at least one electrically conductive layer structure and at least one electrically insulating layer structure, arranging a thermally conductive and electrically conductive block in the stack, forming a vertical hole extending through at least part of the stack and through the entire block to thereby form a nail head structure of the block around the vertical hole, wherein the nail head structure protrudes downwardly beyond a planar portion of a lower main surface of the block and protrudes upwardly beyond a planar portion of an upper main surface of the block, and forming a contact structure (in particular an electrically conductive contact structure) in at least part of the vertical hole to thereby establish a connection (in particular an electrically conductive connection) with the block along the nail head section.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of nonconsecutive islands within a common plane.

In the context of the present application, the term "electronic component" may particularly denote any component fulfilling an electronic task. For instance such an electronic component may be a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the semiconductor component may be a semiconductor chip such as a naked die or a molded die.

In the context of the present application, the term "laminating" may particularly denote connecting by the application of heat and/or mechanical pressure. In particular, laminating an electronic component within a stack of layer structures may be accomplished by curing a previously at least partially uncured layer structure (such as a resin or prepreg sheet) triggered by heat and/or mechanical pressure. By heat and/or pressure, the previously at least partially uncured layer structure may become temporarily flowable so as to flow into gaps between the respective electronic component and the layer structures of the stack, may undergo a curing process (in particular by polymerizing, cross-linking, etc.), and may then be resolidified. Hence, lamination may interconnect in particular planar solid layer structures with the respective electronic component by heating and/or applying pressure (rather than by molding).

In the context of the present application, the term "thermally conductive (and preferably at least partially electrically) conductive block" may particularly denote a bulky body (such as a body shaped as a cuboid or cylinder or disc) made of a material having a high thermal conductivity and, preferably but not necessarily, high electrical conductivity. In terms of electrical conductivity, a highly electrically conductive block may have a metallic conductivity, i.e. an electrical conductivity as a metal. For instance, the electrical conductivity of the electrically highly conductive body at 20°C may be at least 5.10⁶ S/m, in particular at least 2·10⁷ S/m. In terms of thermal conductivity, the thermal conductivity of the material of a thermally highly conductive block may be at least 35 W/mK, in particular at least 100 W/mK.

In the context of the present application, the term "vertical hole" may particularly denote a recess extending into the component carrier in a direction being substantially perpendicular to a planar main surface of the component carrier or a layer stack thereof.

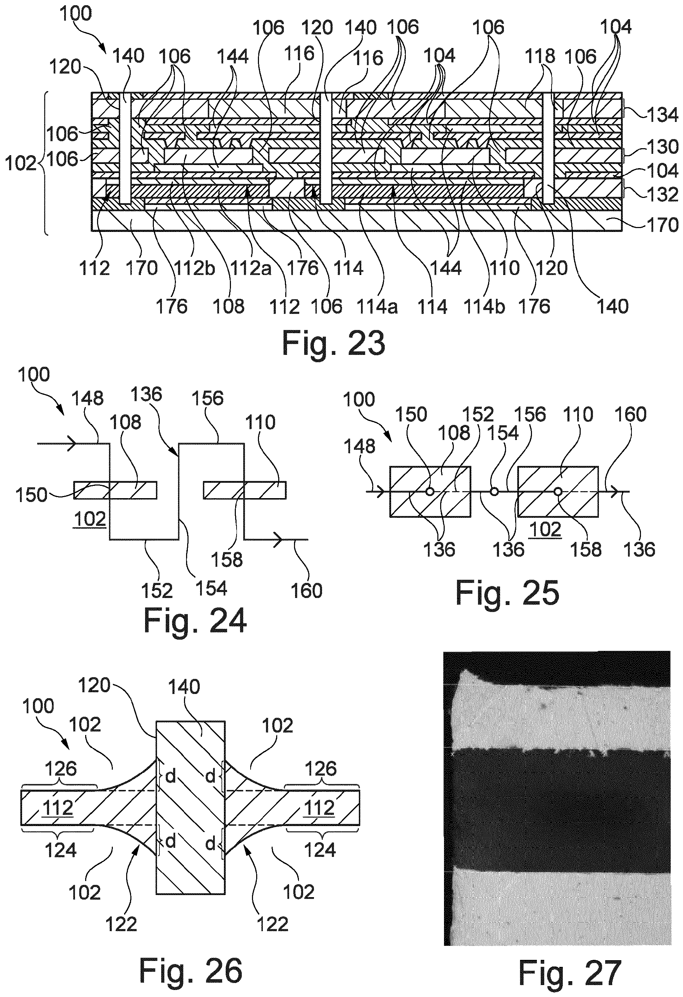

In the context of the present application, the term "nail head structure" may particularly denote a portion of the block being shaped, in a cross-sectional view of the component carrier, as a horizontally aligned nail head (see for instance Figure 26). More specifically, such a nail head structure may have, in the cross-sectional view of the component carrier, a tapering portion tapering inwardly from the vertical hole towards a narrower rectangular portion. At the end of the nail head structure with its largest diameter in the cross-sectional view, the nail head structure may have a vertical line. Descriptively speaking, such a nail head structure may be formed by creating the vertical hole extending through the entire block with sufficient energy impact during the hole formation process. Without wishing to be bound to a specific theory, it is presently believed that said energy impact may create a deformation which may be due to the ductile deformation of copper (or other material) to form the nail head structure. In particular, such a nail head structure may be formed mechanically by a rotating drill bit. Alternatively, it is possible to create a nail head structure by a laser beam having a sufficient power and being used for laser drilling the vertical hole. When reaching the (in particular metallic) block, material of the block may be deformed and may then create the nail head structure. Such a nail head structure may be present along only part of or along the entire perimeter of the vertical hole. Depending on the process parameters during drilling, it may be possible that the nail head structure will not extend entirely along the perimeter.

In the context of the present application, the term "electrically conductive contact structure" may particularly denote a member or a material being electrically conductive, being arranged in only part of (for instance only covering sidewalls of) or in the entire vertical hole and being in direct physical contact with the block through which the vertical hole extends so that electric current can be conducted between the electrically conductive contact structure and the block.

According to an exemplary embodiment of the first aspect of the invention, a component carrier is provided which has embedded in an interior thereof, in particular completely within stack material, electronic components such as silicon chips, and highly conductive blocks connected to the electronic components. Advantageously, the embedded electronic components and the embedded blocks may be thermally and/or electrically coupled with one another. By taking this measure, it is efficiently possible to conduct electricity and/or heat from the electronic components generated during operation of the component carrier away from an interior of the component carrier (in particular up to a periphery) via highly conductive blocks with low electric resistance and/or low thermal resistance and with short thermal and/or electric path(s). This improves the electric performance and/or the thermal performance and thus the overall reliability of the component carrier since undesired effects such as the generation of thermal stress and consequently undesired phenomena such as warpage may be strongly suppressed. In particular when electrically coupling embedded electronic components and embedded blocks, extremely high electric current (for example of 100 Ampère or more) can be conducted through the bulky blocks without excessive heating of the component carrier. It may also be possible to use the blocks synergistically to remove considerable amount of heat generated by such a high current operation of the component carrier. Highly advantageously, an exemplary embodiment may laminate two electronic components in an interior of a laminated layer stack which results in a simple manufacturing process, a compact design of the component carrier, a proper mechanical protection of the embedded electronic components, and an excellent removal of heat created by the electronic components during operation of the component carrier. Said excellent thermal performance of the component carrier may be promoted by cooling each of the electronic components on each of two respective opposing main surfaces thereof using a pair of thermally conductive and at least partially electrically conductive blocks embedded (preferably also by lamination) above and below each electronic component. Hence, heat removal paths may be established for each electronic component not only in one direction, but simultaneously in two opposing directions up to both exterior main surfaces of the component carrier. By laminating the electronic components in the stack, the space consumption may be kept small. Moreover, this may avoid a further material bridge, as caused by molding. Avoiding said additional material bridge by lamination may further improve the heat removal capability, may suppress the tendency of formation of thermal stress in an interior of the stack and may thereby reduce or even eliminate undesired phenomena such as delamination and warpage. Moreover, the described manufacturing architecture and component carrier design may enable to transport high current with efficient cooling simultaneously. In particular, it may be possible to efficiently carry out embedding of an electronic component in one single lamination stage which may simplify the manufacturing process.

According to an aspect of the invention, a component carrier is provided which has a thermally and electrically conductive block embedded in a (preferably laminated) layer stack, wherein said block may be electrically and/or thermally connected to an electrically conductive contact structure in a vertical hole extending also through the entire block. Highly advantageously, the block may have a nail head structure in an interface region with the electrically conductive contact structure which locally increases the connection area. Thus, such a nail head structure may increase the contact area between block and contact structure by locally widening the block both upwardly and downwardly adjacent to the vertical hole. Such a nail head structure can be created by a sufficiently high energy impact during formation of the through hole extending through the entire block, in particular by mechanically drilling with high rotation speed or laser drilling with a high energetic laser beam. Without wishing to be bound to a specific theory, it is presently believed that such an energy impact results in a deformation which may be due to the ductile deformation of (in particular metallic) block material, which creates the nail head structure. By carrying out the mechanical drilling or laser drilling (or other kind of vertical hole formation) process with sufficient energy impact into surrounding metallic block material, formation of the nail head structure becomes possible which advantageously increases the contact area between block and contact structure. Consequently, an improved thermal and electric coupling may be obtained.

In the following, further exemplary embodiments of the manufacturing methods, and the component carriers will be explained.

The blocks may be embedded, for instance by lamination, into the stack. However, it is also possible to in-situ manufacture the copper blocks during the processing. Instead of embedding copper blocks, a thick copper foil can be applied (also by lamination), and recesses between the blocks can be etched away.

In particular, the first electronic component and the second electronic component may be located at the same vertical level, and in particular on and/or in the same layer structure(s) of the stack. The first electronic component may be thermally and/or electrically coupled with the first block and the third block. The second electronic component may be thermally and/or electrically coupled with the second block and the fourth block. The first electronic component and the second electronic component may be electrically coupled.

In an embodiment, each of said blocks is electrically and thermally coupled with at least one of the first electronic component and the second electronic component. In particular, in addition to their heat removal function, the blocks may also contribute to a current flow. This may keep the overall ohmic resistance and thus losses small. Furthermore, the double function of the blocks in terms of heat removal and electric signal transport may enable the manufacture of a compact module-type component carrier.

In an embodiment, each of the first electronic component and the second electronic component is a semiconductor chip, in particular at least one of a semiconductor power chip and a transistor chip. Such a semiconductor chip may be embodied for instance in silicon, silicon carbide or gallium nitride technology. When embodied as a transistor chip, the respective electronic component may be for example a field effect transistor chip (in particular a metal oxide semiconductor field effect transistor, MOSFET, chip) or a bipolar transistor chip (in particular an insulated gate bipolar transistor, IGBT, chip). In view of the short current paths and the efficient heat removal by the thermally conductive blocks on both sides of each embedded electronic component, the component carrier is highly appropriate for power semiconductor applications.

In an embodiment, the stack comprises only laminated layer structures. In particular, the stack may be free of mold compound. By interconnecting all constituents of the stack by lamination rather than by molding, the introduction of an additional material type (in particular a mold compound) into the component carrier may be avoided, which keeps the thermal stress in the event of temperature changes small.

In an embodiment, at least one of said blocks comprises one of the group consisting of a metal block, in particular a copper block, a ceramic block (such as an aluminum nitride block) covered with an electrically conductive layer on at least one of two opposing main surfaces thereof, and a ceramic block (in particular a pure ceramic block, i.e. without metal coating). In one embodiment, a block may be a copper block. Highly advantageously, copper has a high thermal and electric conductivity. Moreover, implementing copper in a component carrier such as a printed circuit board (PCB) does not involve an additional material, which has advantages in terms of keeping CTE (coefficient of thermal expansion) mismatch small. Alternatively, it is possible to embody a block as ceramic block, for instance made of aluminum nitride. Such a ceramic material has a high thermal conductivity and can be rendered electrically conductive (so as to contribute also to the conductance of electricity within the component carrier) by partially or entirely cladding the ceramic block with a metal such as copper. For instance, both a top surface and a bottom surface of the ceramic block may be only partially covered with a copper layer.

In an embodiment, the component carrier comprises a first core on and/or within which the first electronic component and the second electronic component are implemented or arranged (in particular mounted), a second core on and/or within which the first block and the second block are implemented or arranged (in particular mounted), and a third core on and/or within which the third block and the fourth block are implemented or arranged (in particular mounted). Thus, the component carrier may be formed by interconnecting three pre-formed cores, wherein two exterior cores may have embedded therein thermally conductive and at least partially electrically conductive blocks, whereas a central core has electronic components (such as metal oxide semiconductor field effect transistor chips, MOSFETs) mounted thereon and/or therein, for instance by (preferably silver) sintering. A core may denote a thick and fully cured electrically insulating layer structure. Advantageously, the use of three cores for accommodating the components and the blocks may allow to implement separate technologies for handling the thermally conductive and at least partially electrically conductive blocks (such as copper blocks handled in PCB technology) on the one hand, and the assembly of the electronic components (for instance sinter connecting MOSFETs) on the other hand. Is also possible that the copper blocks are manufactured in-situ or as self-made copper blocks.

In an embodiment, the first electronic component and the second electronic component operate with a vertical current flow between opposing main surfaces thereof. In particular, each of the electronic components may be embodied as semiconductor chip with vertical current flow. For example, an electronic component embodied as field-effect transistor chip may have a source pad and a gate pad on one main surface and a drain pad on the opposing other main surface. During operation, the electric current may then flow through the semiconductor body between the pads on the two opposing main surfaces. Advantageously, the implementation of electronic components with vertical current flow may keep the component carrier compact and may reduce the parasitic capacitance.

In an embodiment, the component carrier comprises a continuous electrically conductive path which includes the at least one electrically conductive layer structure, said blocks, the first electronic component and the second electronic component. In particular, said blocks may advantageously contribute to an electric function of the component carrier in addition to their thermal heat removal capability.

In an embodiment, the component carrier comprises at least one vertical hole (such as a mechanical or laser drill hole) extending through at least part of the stack and extending entirely through at least one of said blocks, wherein the at least one vertical hole is filled with an electrically conductive structure. Preferably, such a vertical hole may be formed by mechanically drilling through the entire block and through part of the stack. It is also possible to form parts of or even the entire hole by etching. After formation of the vertical hole, which may be a through hole or a blind hole, the vertical hole may be filled partially or entirely with an electrically conductive material such as copper. For example, only sidewalls of the vertical hole may be coated or lined with electrically conductive material, whereas a central part of the vertical hole may remain hollow. Alternatively, the entire volume of the vertical hole may be filled with an electrically conductive material. For example, filling the vertical hole partially or entirely may be accomplished by electroless plating, optionally followed by galvanic plating.

As described in the preceding paragraph, the contact structure may comprise a plated metal structure. However, it is also possible that the contact structure is embodied as a separate member such as a metal pin which may be inserted or pressed into the vertical hole. After formation of the vertical hole, a pre-formed metallic pin may thus be inserted into the vertical hole to thereby form or establish an electrically and thermally conductive connection with the block traversed or penetrated by the vertical hole.

In an embodiment, the above mentioned continuous electrically conductive path may also include the electrically conductive structure in said vertical hole. In particular a nail head structure which may be formed at an interface between the metal-filled vertical hole and the metallic block traversed entirely by the vertical hole may ensure a low ohmic connection with high contact area.

In an embodiment, the component carrier comprises at least one vertical hole extending through at least part of the stack and connecting, in particular electrically connecting, at least two of said blocks, in particular embodied as copper blocks, with each other. This may allow to establish short electric paths (for keeping losses small) and/or thermal paths (for efficiently removing heat).

In an embodiment, a current path being configured for high power applications, in particular for an electric voltage transport of at least 20 kV, is established through the first electronic component and the second electronic component. Hence, an electronic device with high electric performance may be obtained.

In an embodiment, the first electronic component is mounted on the first block and the second electronic component is mounted on the second block by a connection medium. In particular, the connection medium may comprise one of the group consisting of a sinter structure, a solder structure, and an adhesive. By such a connection medium, a low ohmic and thermally highly conductive coupling between electronic component and assigned bottom-sided block may be established. A silver sinter medium or a diffusion bonding medium may be preferred. It may also be possible to establish the connection by thermal compression bonding.

In an embodiment, the blocks are configured for conducting electricity between the first electronic component and the second electronic component and are configured for removing heat out of the component carrier. Since the blocks may be configured and interconnected for fulfilling a thermal and electric double function, a compact component carrier may be created with high electrical and thermal performance.

In an embodiment, in a cross-sectional view of the component carrier, the above-mentioned current path is established which has a horizontal section, a subsequent vertical section extending through the first electronic component, a subsequent horizontal section, a subsequent vertical section extending between the first electronic component and the second electronic component, a subsequent horizontal section, a subsequent vertical section extending through the second electronic component, and a subsequent horizontal section. By the described current trajectory with vertical paths extending through the respective electronic components and one or more metal-filled vertical holes, and horizontal paths extending along the electrically conductive layer structures and/or the at least partially electrically conductive blocks, it is possible to significantly reduce the parasitic capacitance, which may reduce losses and signal distortions.

In an embodiment, the first electronic component and the second electronic component are configured and are interconnected by the blocks and the at least one electrically conductive layer structure to provide a half-bridge function. A half-bridge may be a current converter using switches to control an output voltage. For instance, a half-bridge may be implemented in a motor control.

In an embodiment, the stack comprises a plurality of electrically insulating layer structures, wherein at least one electrically insulating layer structure (in particular an uppermost and/or a lowermost electrically insulating layer structure) of the stack has a higher thermal conductivity compared to at least one remaining electrically insulating layer structure of the stack. The one or more electrically insulating layer structure(s) having a higher thermal conductivity than the other(s) may be for example a thermal prepreg which may have, for example, a thermal conductivity of at least 1.0 W/mK, in particular of at least 1.8 W/mK, and preferably of at least 2 W/mK. Consequently, such a thermal prepreg may provide a pronounced contribution to the heat removal and may therefore be most effective at an exterior position of the stack. The one or more remaining electrically insulating layer structures may for instance be made of ordinary prepreg and may have, for example, a thermal conductivity of 0.3 W/mK to 0.8 W/mK.

In an embodiment, the nail head structure protrudes upwardly and/or downwardly beyond the respective planar portion by a value in a range from 5 µm to 70 µm, in particular by a value in a range from 50 µm to 70 µm. With such dimensions of the upper and/or lower extension of the nail head structure beyond the planar portion of the block, an increase of a contact area between electrically conductive contact structure and nail head structure may be so pronounced that a high mechanical and electrical reliability may be obtained in this interface region.

In an embodiment referring to the formation of a nail head structure, the block may comprise or consists of a metal, in particular copper. Copper has turned out as particularly appropriate for creating a nail head structure with pronounced extension at the upper and at the lower side when impacted preferably by a mechanical drill bit (or alternatively by a laser beam) introducing thermal energy in the block during drilling. Alternatively, the block used for the formation of a nail head structure comprises a metal coated ceramic.

In an embodiment, the component carrier comprises a stack comprising a plurality of electrically insulating layer structures and a plurality of electrically conductive layer structures. For example, the component carrier may be a laminate of the mentioned electrically insulating layer structures and electrically conductive layer structures, in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the plurality of electrically insulating layer structures comprise at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the plurality of electrically conductive layer structures comprise at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 to Figure 22 illustrate cross-sectional views of structures obtained during carrying out methods of manufacturing component carriers according to exemplary embodiments of the invention.
Figure 23 illustrates a cross-sectional view of a component carrier according to another exemplary embodiment of the invention.
Figure 24 illustrates a cross-sectional view and Figure 25 illustrates a plan view showing a path of electric current flowing through a component carrier according to an exemplary embodiment of the invention.
Figure 26 illustrates a cross-sectional view of a part of a component carrier according to still another exemplary embodiment of the invention.
Figure 27 illustrates a cross-sectional view of a part of a component carrier according an exemplary embodiment of the invention with a nail head structure.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an embodiment of the invention, a component carrier is provided which has at least two electronic components (such as semiconductor chips) creating a significant amount of heat during operation. These electronic components are embedded in a layer stack by lamination. For heat removal, each of the electronic components is provided with an assigned pair of thermally conductive and at least partly electrically conductive blocks (for instance copper blocks) being embedded in the stack as well and being arranged above and below each respective electronic component. This may combine a compact design, a simple manufacturing process, a high thermal performance and a proper mechanical and electrically reliability of the obtained component carrier. In particular, an exemplary embodiment relates to a chip-on-block arrangement integrated in a component carrier and having an additional block assigned to the same chip on the top side. Such an embodiment may overcome conventional limitations in terms of current carrying capability in a horizontal plane of a component carrier caused by limited copper layer thickness (of conventionally 70 µm at the maximum). Conventionally, higher current values require multiple power layers which increases the space consumption. In contrast to such conventional approaches, exemplary embodiments of the invention may enable to transport higher current in particular along one or more vertically extending holes connected to blocks (such as metal inlays) which may extend predominantly in a horizontal plane.

In such an architecture, a gate connection of a transistor chip-type electronic component can be realized with thin copper technology. This is properly compatible with a small pad size and a spacing between gate and source. A component carrier according to an exemplary embodiment of the invention may be manufactured based on cores with embedded copper blocks which can be prefabricated, thereby simplifying the manufacturing process. In particular, it may be possible to use sintered and/or diffusion soldered interconnections to establish full area metal interconnection in particular on a drain side of a transistor chip-type electronic component. The use of sintered cores with embedded copper blocks may also enable to transport heat in a horizontal plane and in a vertical direction of the component carrier. For example, an electrically conductive contact between gate and source of transistor chip-type electronic components may be accomplished by microvias. Laminating the electronic components in the stack may allow to embed or encapsulate electronic components (in particular embodied as MOSFET chips) with printed circuit board (PCB) material. This may avoid the addition of other materials such as a mold compound. In particular, it may be advantageous to use vertical through holes and metal inlays to transmit current through the module-type component carrier. Thus, the blocks may have a double function of removing heat (by increasing thermal conductivity) and conducting current.

Advantageously, a component carrier according to an exemplary embodiment of the invention may allow simultaneously to transport a high current and to provide an efficient cooling. It may be possible to embed electronic components with silver backside metallization so that a pad-metallization on the backside of an electronic component may be dispensable. Furthermore, it may be possible to connect a gate pad of an electronic component with thin copper lines, whereas source and drain pad may be connected with thick lines (which may be formed by a copper block and copper wires) to transfer high current and heat. Furthermore, the manufacturing architecture may be significantly simplified by embedding the electronic components by lamination, preferably in a single lamination process. Exemplary embodiments may be highly appropriate for high power applications, for instance using wide band gap semiconductors such as SiC or GaN. For power electronics applications, the cooling concept with thermally conductive blocks on both opposing main surfaces of each electronic component of the component carrier may make it possible to transport high current in parallel. Hence, exemplary embodiments of the invention may transport a high current in a PCB-type component carrier with embedded power components (or with an embedded system of electronic components inside) and by removing generated heat out of it in parallel.

In one embodiment of the invention, power components may be placed onto a manufactured core with integrated cooling block (which may for instance be made of a metal such as copper and/or a ceramic such as aluminum nitride) and may be embedded in one single process by lamination and sintering. A corresponding power component may be placed with the bottom side of the device onto a sinter depot printed in advance on the core with the cooling block. This may render the manufacturing process simple and may in particular avoid the lamination and subsequent removal of a carrier tape during manufacturing. In a further lamination stage, a core with a cooling block may be applied on top.

According to another exemplary embodiment of the invention, a component carrier with embedded thermally and electrically conductive block is provided in which a vertical hole is formed. The latter may be filled at least partially with an electrically conductive contact structure, such as a copper pin or a plating structure. Highly advantageously, the block may be provided with a nail head structure in a contact region to the contact structure, which increases their mutual contact area and thereby reduces the thermal and electrical contact resistance. The nail head structure of the block may extend up to the vertical hole, i.e. may partially delimit the vertical hole along its entire perimeter. Advantageously, such a nail head structure may be formed by an energy impact during formation of the through hole extending through the entire block, in particular by mechanically drilling using a rapidly rotating drill bit or laser drilling by a pulsed or continuous highly energetic laser beam.

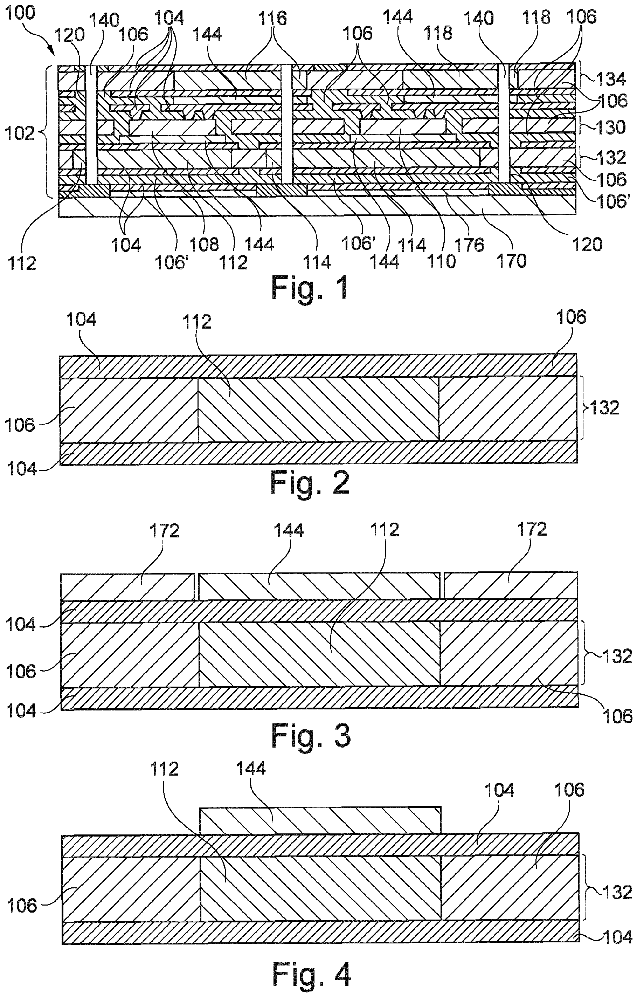

**Figure 1** illustrates a cross-sectional view of a component carrier 100 according to an exemplary embodiment of the invention.

As shown, component carrier 100 comprises a laminated layer stack 102 composed of a plurality of electrically conductive layer structures 104 and a plurality of electrically insulating layer structures 106. Lamination may particularly denote the connection of the layer structures 104, 106 by the application of pressure and/or heat. For example, the electrically conductive layer structure(s) 104 may comprise patterned or continuous copper foils (as shown) and vertical through-connections, for example copper filled laser vias which may be created by plating. The electrically insulating layer structure(s) 106 may comprise a respective resin (such as a respective epoxy resin), preferably comprising reinforcing particles therein (for instance glass fibers or glass spheres). For instance, the electrically insulating layer structures 106 may be made of prepreg or FR4. In the shown embodiment, the entire stack 102 is made of laminated layer structures 104, 106 only and is free of mold compound. Hence, the material of the laminated layer stack 102 is substantially homogeneous and does not involve a pronounced CTE mismatch. This keeps thermal tensions and stress in an interior of the stack 102 small.

A first electronic component 108 and a second electronic component 110 are embedded in a central portion of the stack 102 by lamination and are located at the same vertical level. Each of the electronic components 108, 110 may be embodied as a power semiconductor transistor chip (more specifically a MOSFET) with vertical current flow. For instance, the first electronic component 108 and the second electronic component 110 may be configured and may be interconnected by copper blocks 112, 114, 116, 118 and the electrically conductive layer structures 104 to provide a half-bridge function. The electronic components 108, 110 may create a significant amount of heat during operation of the component carrier 100.

As shown, a thermally conductive and electrically conductive first block 112 and a thermally conductive and electrically conductive second block 114 are also embedded in the stack 102 at the same vertical level by lamination and are both arranged below the first electronic component 108 and the second electronic component 110. More specifically, first block 112 is located below and is electrically and thermally connected with the first component 108. As shown, the first block 112 extends over the entire lateral extension of the first component 108 and extends even beyond the lateral edges of the first component 108. Correspondingly, second block 114 is located below and is electrically and thermally connected with the second component 110. Furthermore, the second block 114 extends over the entire lateral extension of the second component 110 and extends even beyond lateral edges of the second component 110. The stacked arrangement of the first block 112 and the first component 108 is arranged side-by-side to the stacked arrangement of the second block 114 and the second component 110. In the shown embodiment, blocks 112, 114 may be copper blocks.

Furthermore, a third block 116 and a fourth block 118 are embedded in the stack 102 by lamination, are located at the same vertical level, and are arranged above the first electronic component 108 and the second electronic component 110. More specifically, third block 116 is located above and is electrically and thermally connected with the first component 108. As shown, the third block 116 laterally overlaps with the first component 108. Correspondingly, fourth block 118 is located above and is electrically and thermally connected with the second component 110. Furthermore, the fourth block 118 laterally overlaps with the second component 110. In the shown embodiment, blocks 116, 118 may be copper blocks.

As an alternative to such metallic inlays, it is also possible to implement ceramic inlays (which may be cladded by metal) as one or more of the blocks 112, 114, 116, 118 to transport current and/or heat. For instance, DCB (Direct Copper Bonding) substrates or pieces may also be used as blocks 112, 114, 116, 118.

More specifically, the stack 102 of the component carrier 100 is composed of a first core 130 in which the first electronic component 108 and the second electronic component 110 are mounted, a second core 132 in which the first block 112 and the second block 114 are mounted, and a third core 134 in which the third block 116 and the fourth block 118 are mounted. Each respective core 130, 132, 134 may comprise a thick central electrically insulating layer structure 106 which may be made of fully cured FR4 material, and which may or may not be optionally covered on each of the two opposing main surfaces thereof with a respective electrically conductive layer structure 104, such as a patterned copper foil.

Similar as in Figure 24 and Figure 25, a continuous electrically conductive path (see reference sign 136 in Figure 24 and Figure 25) may be formed by the electrically conductive layer structures 104, the blocks 112, 114, 116, 118, the first electronic component 108 and the second electronic component 110 as well as by electrically conductive structures 140 in vertical holes 120 described below. Thus, blocks 112, 114, 116, 118 may fulfil a double function. On the one hand, they may contribute to the conductance of electricity through the electronic components 108, 110 in an interior of the component carrier 100. At the same time, they may remove heat created by the electronic components 108, 110 during operation of the component carrier 100 both towards an upper main surface and a lower main surface according to Figure 1. This may ensure an efficient double-sided cooling rendering component carrier 100 particularly appropriate for high-power applications.

As shown in Figure 1 as well, component carrier 100 has several vertical holes 120 extending from an upper main surface of the component carrier 100 through an upper part of the stack 102 and through one or two of the blocks 112, 114, 116, 118. More specifically, one of the vertical holes 120 extends only through first block 112 as well as through portions of the stack 102 above and below the first block 112. Another one of the vertical holes 120 extends only through fourth block 118 as well as through portions of the stack 102 above and below the fourth block 118. Yet another vertical hole 120 extends entirely through second block 114 and entirely through third block 116 as well as through portions of the stack 102 below second block 114, above third block 116 and between second block 114 and third block 116. Each of said vertical holes 120 may be filled partially or entirely with an electrically conductive structure 140. The vertical holes 120 may be formed by mechanically drilling, or alternatively by laser drilling or etching. The vertical holes 120 may be filled with electrically conductive structures 140 by plating (in particular by electroless plating and/or galvanically plating). Alternatively, the vertical holes 120 may be filled with electrically conductive structure 140 by inserting a respective metallic pin in each respective vertical hole 120. The above-mentioned continuous electrically conductive path (see reference sign 136 in Figure 24 and Figure 25) may also include (partially or entirely) the electrically conductive structures 140 in said vertical holes 120. Hence, a current transport in component carrier 100 may be accomplished inter alia via the metal-filled vertical holes 120.

The first electronic component 108 may be mounted on the first block 112 by a connection medium 144. Correspondingly, the second electronic component 110 may be mounted on the second block 114 by a connection medium 144. Preferably, the connection medium 144 may be a sinter structure (such as a silver sinter structure). Thus, it may in particular be possible to embed electronic components 108, 110 with silver backside metallization. Hence, a copper pad metallization on the backside may be dispensable for the power components 108, 110. Alternatively, it may also be possible that the connection medium 144 is a solder structure (in particular configured for diffusing soldering) or is an electrically conductive adhesive. In particular, it may be possible to connect a gate pad of a respective one of the electronic components 108, 110 with thin copper lines, whereas source pad and drain pad may be connected with thick metal (for instance by a respective block 112, 114 and the electrically conductive layer structures 104) to transfer high current and heat. In the shown embodiment, the electronic components 108, 110 are connected on a bottom side with the blocks 112, 114, respectively, by the described connection medium 144. On a top side, the electronic components 108, 110 may be connected by microvias.

According to Figure 1, a lowermost electrically insulating layer structure 106' of the stack 102 may be a thermal prepreg which has a higher thermal conductivity (for example 1.8 W/mK) compared to the other electrically insulating layer structures 106 of the stack 102 which may have a lower thermal conductivity (for example 0.8 W/mK). Said thermal prepreg layer may provide a pronounced contribution to the heat removal towards a cooling unit 170.

As shown in Figure 1, stack 102 may be mounted on the cooling unit 170 (such as a heat sink) with a thermal interface material 176 (which may be thermally conductive and electrically insulating) in between.

Figure 2 to Figure 23 illustrate cross-sectional views of structures obtained during carrying out methods of manufacturing component carriers 100 according to exemplary embodiments of the invention in accordance with a chip-on-block concept.

Referring to **Figure 2****,** core 132 is shown as a thick and fully cured electrically insulating layer structure 106 (in particular made of FR4) having electrically conductive layer structures 104 attached to both opposing main surfaces thereof, for example copper foils. First block 112 is embedded in the core 132. Thus, core 132 may be fabricated with an embedded copper (or aluminum nitride) cuboid as first block 112.

**Figure 3** shows a sinter depot printed as connection medium 144 on top of the structure shown in Figure 2 using a stencil printing mask 172.

Referring to **Figure 4****,** the stencil printing mask 172 is removed after printing the connection medium 144 embodied as sinter depot.

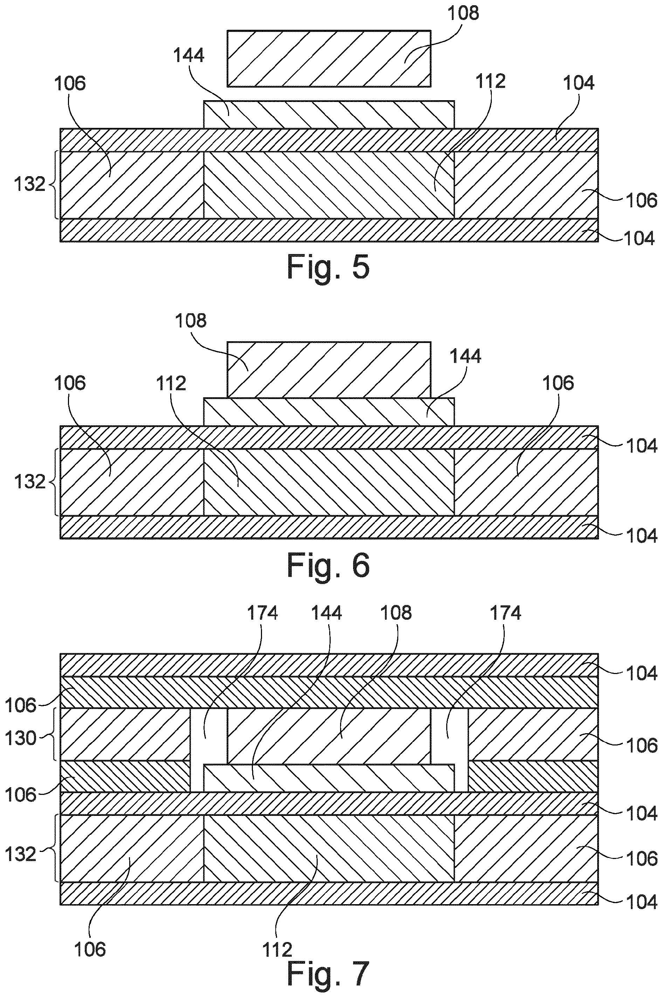

**Figure 5** shows how the first electronic component 108 is mounted or assembled on the connection medium 144. This may be accomplished by a pick and place process. As a result, the first electronic component 108 (for instance a MOSFET formed in silicon, GaN or SiC technology, an IGBT, or a diode) is arranged on the sinter depot, compare **Figure 6** . It may be optionally possible to apply mechanical pressure and/or raise the temperature during assembly of the first electronic component 108 to promote adhesion on the connection medium 144.

Referring to **Figure 7****,** a fully cured core 130 (for instance fully cured FR4) covered on both opposing main surfaces thereof with a respective at least partially uncured electrically insulating layer structure 106 (such as B-stage prepreg or resin) and having an additional electrically conductive layer structure 104 (such as a copper foil) on top may be provided with a recess or cavity 174 and may be placed on top of the structure of Figure 6. More specifically, cavity 174 may be formed in core 130 and in the lower uncured electrically insulating layer structure 106 to thereby form a cap structure. As a result of putting the cap structure on the structure shown in Figure 6, the first electronic component 108 and the connection medium 144 are accommodated in the cavity 174. Thus, a lay-up of a pre-cut prepreg, a pre-cut core 130 (optionally with structured copper layer, not shown), a continuous sheet of prepreg and a continuous copper foil may be provided and placed on top of the electronic component 108.

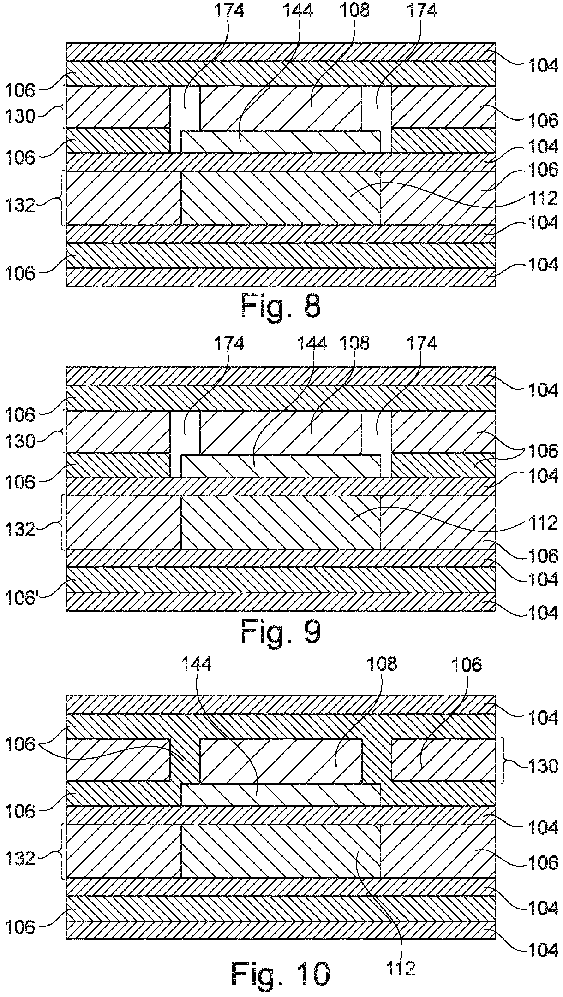

Referring to **Figure 8****,** a further electrically conductive layer structure 104 (such as the copper foil) and a further uncured electrically insulating layer structure 106 (such as a prepreg sheet) may be attached to a lower main surface of the structure shown in Figure 7. Hence, a lay-up of prepreg (in this embodiment a normal prepreg) may be applied on a bottom side of the structure of Figure 7. According to Figure 8, the standard prepreg used as lowermost electrically insulating layer structure 106 may have a thermal conductivity of not more than 1.0 W/mK, in particular of not more than 0.8 W/mK. Thermal vias may be formed on a bottom side.

**Figure 9** is an alternative to the structure according to Figure 8 and may also be obtained based on the structure shown in Figure 7. According to Figure 9, a thermal prepreg may be applied as uncured electrically insulating layer structure 106' at a bottom side, together with a further electrically conductive layer structure 104. For instance, the thermal prepreg may have a thermal conductivity of more than 1.0 W/mK, in particular of more than 1.8 W/mK. For instance, no thermal vias are formed on the bottom side of the structure of Figure 9.

Hence, the embodiments of Figure 8 and Figure 9 differ concerning the thermal conductivity of the lowermost electrically insulating layer structures 106/106' and/or concerning the presence or absence of thermal vias.

After having formed the structures shown in Figure 8 and Figure 9, a lamination process may be carried out by the application of pressure and/or heat. Cavities 174 are filled with resin from the previously uncured electrically insulating layer structures 106 during the lamination process. Descriptively speaking, the two at least partially uncured electrically insulating layer structures 106 (one being a continuous sheet and the other one being pre-cut) may become flowable during lamination and may thus flow into cavity 174. By the elevated temperature and/or the mechanical pressure applied during lamination, said previously uncured electrically insulating layer structures 106 may be cured (for instance by polymerizing, cross-linking, etc.) and may thereby be re-solidified.

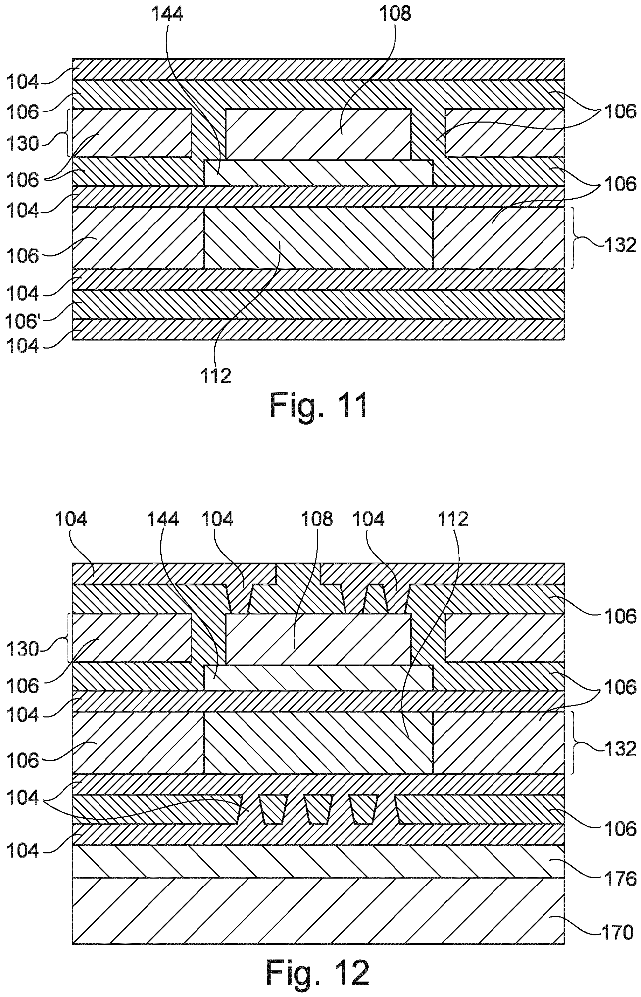

**Figure 10** shows the result of the lamination process starting from the embodiment according to Figure 8. **Figure 11** shows the result of the lamination process starting from the alternative embodiment according to Figure 9.

Thereafter, via drilling may be carried out, for instance by laser drilling. The obtained drill holes may be filled with electrically conductive material such as copper, for instance by plating. The exterior electrically conductive layer structures 104 may then be structured to thereby obtain a patterned metal layer. Subsequently, the stack 102 may be mounted on a cooling unit 170, preferably with a thermal interface material 176 between the stack 102 and the cooling unit 170.

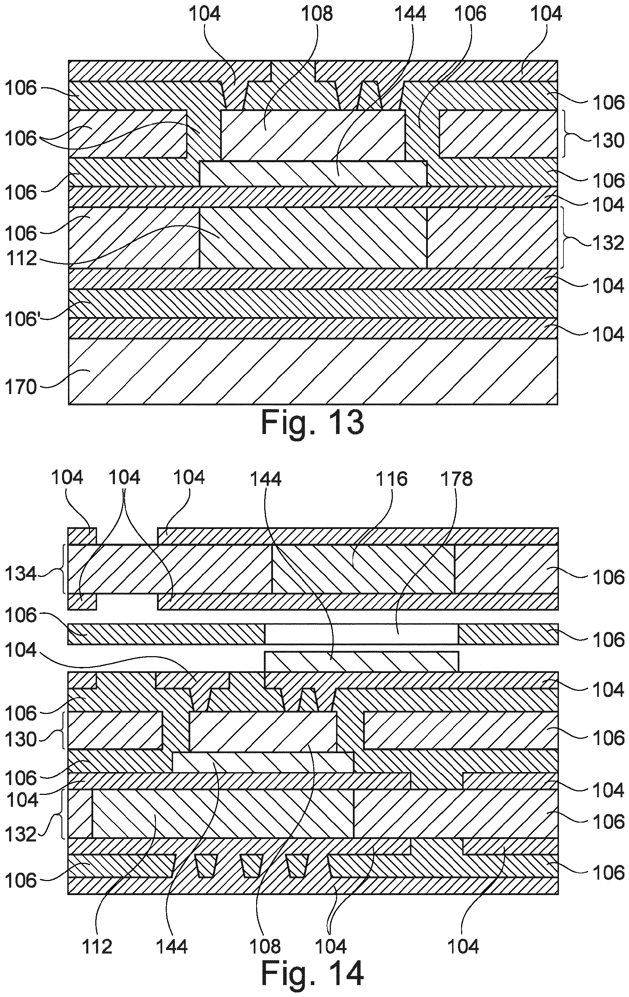

**Figure 12** shows the results of the described processes for the embodiment according to Figure 10, whereas **Figure 13** shows the results of the described processes for the embodiment according to Figure 11.

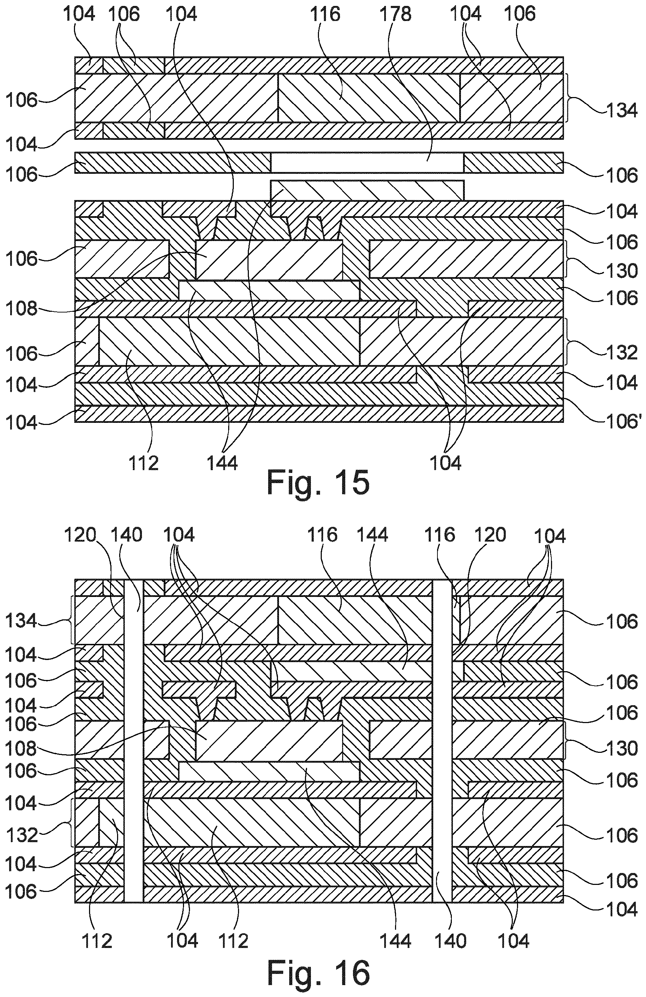

After the described processes of micro via contacting and now referring to **Figure 14** (corresponding to the embodiment of Figure 12) and **Figure 15** (corresponding to the embodiment of Figure 13), the manufacturing process may proceed with applying a connection medium 144 (such as a sinter depot) on the stack-up, i.e. on the upper main surface of the processed layer stack. Apart from this, a further thermally conductive and electrically conductive block 116 may be embedded in a further core 134 which may be cladded with patterned further electrically conductive layer structures 104 on both sides. A further pre-cut uncured electrically insulating layer structure 106, having a through hole 178 aligned with the connection medium 144, may be interposed between the structure shown in Figure 12/Figure 13 with the connection medium 144 thereon on the one hand and the further core 134 with the embedded block 116 on the other hand. Thereafter, said three constituents may be connected by lamination using the interposed further pre-cut uncured electrically insulating layer structure 106 (which may be denoted as pacer prepreg) as source of flowable resin which is cured during lamination.

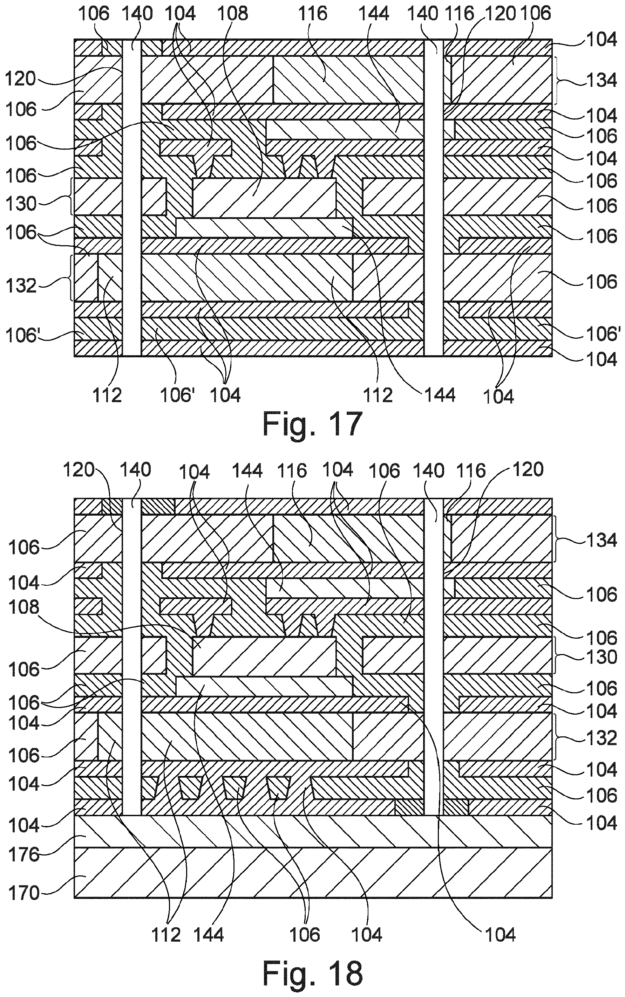

The resulting structures are shown, after drilling of vertical through holes 120 through the entire structures, in **Figure 16** (corresponding to Figure 14) and in **Figure 17** (corresponding to Figure 15), respectively. Drilling the vertical through holes 120 may be accomplished by mechanically drilling. As shown, the vertical holes 120 may also extend through the entire blocks 112, 116. The vertical holes 120 may be filled, partially or entirely, by electrically conductive structures 140. For instance, this may be accomplished by plating. Alternatively, a metallic pin may be inserted in the vertical holes 120 as electrically conductive structure 140.

Referring to **Figure 18****,** the structure of Figure 16 may be connected to thermal interface material 176 and cooling unit 170. As shown in Figure 18, it may also be possible to form micro vias, as described above referring to Figure 12 and Figure 13.

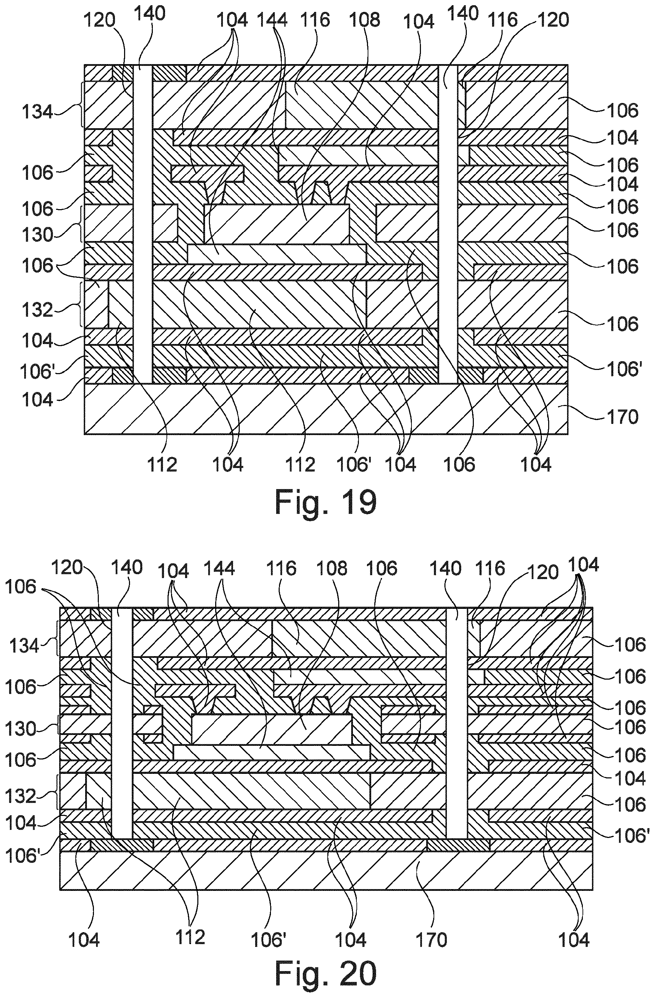

**Figure 19** shows the structure of Figure 17 connected to a cooling unit 170.

**Figure 20** shows a variant to the embodiment of Figure 19 with eight layers, a thermal prepreg on the bottom side, and two press cycles.

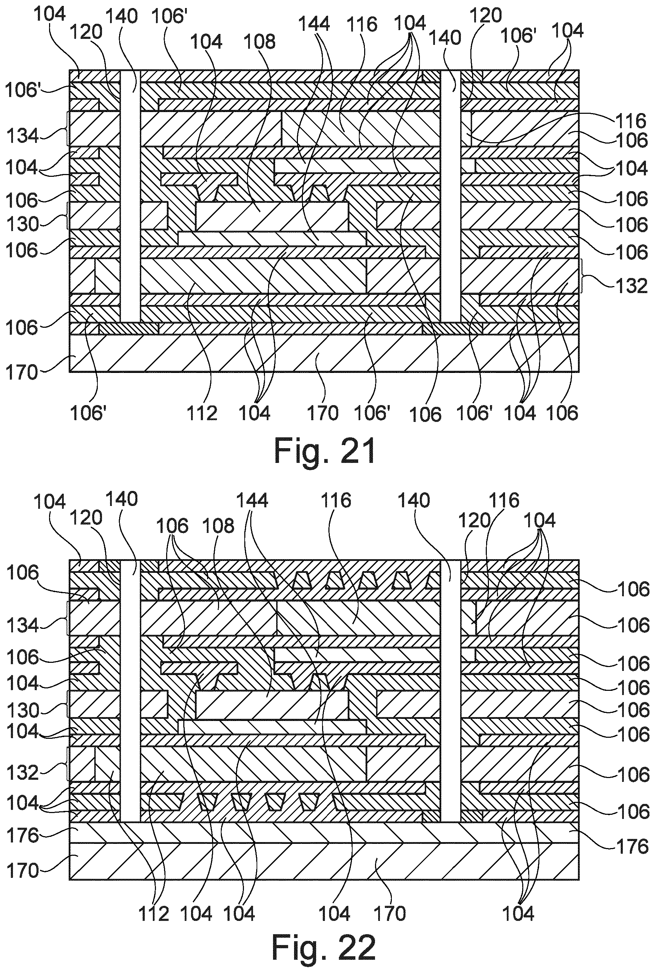

**Figure 21** shows a further variant to the embodiment of Figure 19 with seven layers, a thermal prepreg (see reference sign 106') on the top side and on the bottom side, and three press cycles.

Referring to **Figure 22****,** a variant to the embodiment of Figure 18 with seven layers, an ordinary prepreg on the top side and on the bottom side, and three press cycles is shown.

**Figure 23** illustrates a cross-sectional view of a component carrier 100 according to another exemplary embodiment of the invention. The embodiment of Figure 23 differs from the embodiment of Figure 1 in particular in that, according to Figure 23, each of said blocks 112, 114 (rather than consisting of copper) comprise a respective ceramic block 112a, 114a covered with a respective electrically conductive layer 112b, 114b on a top side (and/or on a bottom side) of the respective ceramic block 112a, 114a. Each ceramic block 112a, 114a may be made for example of aluminum nitride. The embodiment shown in Figure 23 does not have a thermal prepreg on the bottom side, but may have such a thermally conductive electrically insulating layer structure 106' in yet another embodiment.

In particular, the embedded electronic components 108, 110 may be MOSFET chips which can be manufactured for instance in Si, GaN, SiC, GaAs, or GaS technology. Alternatively, the electronic components 108, 110 may be for instance IGBTs, diodes, etc.

All electrically conductive layer structures 104 (in particular copper layers) can be designed as signal layers (for instance made of copper foils or layers having a thickness of 35 µm).

More generally, the electrically conductive layer structures 104 may for instance have a thickness in a range from 10 µm to 50 µm, in particular from 20 µm to 40 µm. The initially uncured electrically insulating layer structures 106 may have a thickness in a range from 10 µm to 80 µm, in particular in a range from 20 µm to 70 µm. The cores 130, 132, 134 may for instance have a thickness in a range from 100 µm to 700 µm, in particular from 200 µm to 500 µm. The blocks 112, 114, 116, 118 may for instance have a thickness of at least 100 µm, in particular in a range from 100 µm to 700 µm, more particularly from 200 µm to 500 µm.

**Figure 24** illustrates a cross-sectional view and **Figure 25** illustrates a plan view showing a path 136 of electric current flowing through a component carrier 100 according to an exemplary embodiment of the invention, in particular the one shown in Figure 1 or in Figure 23.

As shown, in the cross-sectional view of the component carrier 100 according to Figure 24, a current path 136 is established which has a horizontal section 148 (which may correspond to a current flow through an electrically conductive layer structure 104), a subsequent vertical section 150 extending through the first electronic component 108, a subsequent horizontal section 152 (which may correspond to a current flow through connection medium 144 and an electrically conductive layer structure 104), a subsequent vertical section 154 extending between the first electronic component 108 and the second electronic component 110 (which may correspond to a current flow through the central metal filled vertical hole 120), a subsequent horizontal section 156 (which may correspond to a current flow through an electrically conductive layer structure 104), a subsequent vertical section 158 extending through the second electronic component 110, and a subsequent horizontal section 160 (which may correspond to a current flow through a further connection medium 144 and an electrically conductive layer structure 104). The illustrated path 136 provides a very small parasitic capacitance.

**Figure 26** illustrates a cross-sectional view of a part of a component carrier 100 according to still another exemplary embodiment of the invention. However, the features described in the following referring to Figure 26 may be implemented as well in other embodiments of the invention, for instance the ones of Figure 1 or Figure 23. More specifically, Figure 26 shows a detail of component carrier 100 around an intersection between a metal-filled vertical through hole 120 and a copper block 112 traversed by said metal-filled vertical through hole 120.

As shown, the thermally conductive and electrically conductive metal block 112 is embedded in a laminated layer stack 102, which may be constructed as described above. The vertical hole 120 extends through part of the stack 102 and through the entire block 112, and may be formed for example by mechanically drilling. As shown, the block 112 has a nail head structure 122 surrounding the vertical hole 120 circumferentially, protruding downwardly beyond a planar portion 124 of a lower main surface of the block 112 and protruding upwardly beyond a planar portion 126 of an upper main surface of the block 112 (which can be cuboid before drilling). Such a nail head structure 122 may be formed by a ductile deformation of metallic material of block 112 during mechanically drilling or laser drilling the vertical hole 120, i.e. by the drilling energy impact. Descriptively speaking, the copper material may be partially displaced

As shown as well, the electrically conductive contact structure 140 in the vertical hole 120 establishes an electrically conductive connection with the block 112 along the nail head section 122. Due to the vertically elongate geometry of the nail head section 122, the electric contact between the contact structure 140 and the metallic block 112 is highly reliable thanks to the large connection area provided by the nail head section 122. For instance, the contact structure 140 may be a plated metal structure (for instance formed by electroless deposition and/or galvanic deposition) or a metallic pin pressed into the vertical hole 120. As shown, the nail head structure 122 protrudes upwardly and downwardly beyond the respective planar portion 124, 126 by a respective distance, d. Preferably, each of the distances, d, may be in a range from 5 µm to 70 µm which guarantees a highly reliable electrical connection between deformed block 112 and contact structure 140. Descriptively speaking, the nail head structure 122 is created by metal forming of metallic material of the block 112 due to an energy impact by the formation of the vertical hole 120, in particular by mechanically drilling using a drill bit.

The extent of the nail-head structure 122 strongly depends on the process parameters during drilling. The higher the drilling speed the more copper will be displaced (due to its ductile properties) leading to the structure of a nail-head. Another influencing factor is the amount of prepreg present on the surface. The softer the applied material on top of the copper block 112, the larger will be the perimeter of the nail-head structure 122.

**Figure 27** illustrates a cross-sectional view of a part of a component carrier 100 according an exemplary embodiment of the invention with a nail head structure 122. Figure 27 shows a drilled copper inlay, in which the obtained nail-head structure has been obtained by drilling with a low drilling speed. The presence of the nail-head structure 122 can be confirmed with Figure 27.

## Claims

1. A component carrier (100), wherein the component carrier (100) comprises:
a stack (102) comprising a plurality of electrically conductive layer structures (104) and a plurality of electrically insulating layer structures (106);
a first electronic component (108) and a second electronic component (110) laminated in the stack (102);
a first block (112) and a second block (114) arranged in the stack (102) below the first electronic component (108) and the second electronic component (110); and
a third block (116) and a fourth block (118) arranged in the stack (102) above the first electronic component (108) and the second electronic component (110),
wherein said blocks (112, 114, 116, 118) are thermally conductive, and
wherein each of said blocks (112, 114, 116, 118) is electrically and thermally coupled with at least one of the first electronic component (108) and the second electronic component (110),
wherein said stack (102) comprises a first core (130) within which the first electronic component (108) and the second electronic component (110) are arranged, a second core (132) within which the first block (112) and the second block (114) are arranged, and a third core (134) within which the third block (116) and the fourth block (118) are arranged, each of said second core (132) and third core (134) comprises a centrally electrically insulating layer structure (106) covered on each of the two opposing surfaces with a respective electrically conductive layer structure (104), said first electronic component (108) and a second electronic component (110) being connected to one of said electrically conductive layer structures (104) of each said second core (132) and third core (134) through a respective connection medium (144).

2. The component carrier (100) according to claim 1, wherein each of the first electronic component (108) and the second electronic component (110) is a semiconductor chip, in particular at least one of a semiconductor power chip and a transistor chip.

3. The component carrier (100) according to claim 1 or 2, wherein the stack (102) comprises only laminated layer structures (104, 106).

4. The component carrier (100) according to any of claims 1 to 3, wherein at least one of said blocks (112, 114, 116, 118) comprises one of the group consisting of a metal block, in particular a copper block, a ceramic block (112a, 114a) covered with an electrically conductive layer (112b, 114b) on at least one of two opposing main surfaces of the ceramic block (112a, 114a), and a pure ceramic block.

5. The component carrier (100) according to any of claims 1 to 4,
wherein the first electronic component (108) and the second electronic component (110) operate with a vertical current flow between opposing main surfaces thereof.

6. The component carrier (100) according to any of claims 1 to 5, comprising a continuous electrically conductive path (136) which includes the at least one electrically conductive layer structure (104), said blocks (112, 114, 116, 118), the first electronic component (108) and the second electronic component (110).

7. The component carrier (100) according to any of claims 1 to 6, comprising at least one vertical hole (120) extending through at least part of the stack (102) and extending entirely through at least one of said blocks (112, 114, 116, 118), wherein the at least one vertical hole (120) is at least partially filled with an electrically conductive structure (140).

8. The component carrier (100) according to claims 6 and 7, wherein the continuous electrically conductive path (136) includes the electrically conductive structure (140) in said at least one vertical hole (120).

9. The component carrier (100) according to any of claims 1 to 8, comprising at least one of the following features:
wherein the connection medium (144) comprises one of the group consisting of a sinter structure, in particular a silver sinter structure, a solder structure, in particular a diffusion solder structure, and an adhesive, in particular an electrically conductive adhesive;
wherein said blocks (112, 114, 116, 118) are configured for conducting electricity between the first electronic component (108) and the second electronic component (110) and are configured for removing heat from an assigned one of the first electronic component (108) and the second electronic component (110) towards the upper main surface and the lower main surface of the component carrier (100).

10. The component carrier (100) according to any of claims 1 to 9, comprising at least one of the following features:
wherein, in a cross-sectional view of the component carrier (100), a current path (136) is established which has a horizontal section (148), a subsequent vertical section (150) extending through the first electronic component (108), a subsequent horizontal section (152), a subsequent vertical section (154) extending between the first electronic component (108) and the second electronic component (110), a subsequent horizontal section (156), a subsequent vertical section (158) extending through the second electronic component (110), and a subsequent horizontal section (160);
wherein the first electronic component (108) and the second electronic component (110) are configured and are interconnected by the blocks (112, 114, 116, 118) and the at least one electrically conductive layer structure (104) to provide a half-bridge function.

11. The component carrier (100) according to any of claims 1 to 10, comprising at least one of the following features:
wherein the stack (102) comprises a plurality of electrically insulating layer structures (106, 106'), and wherein at least one electrically insulating layer structure (106'), in particular an uppermost and/or a lowermost electrically insulating layer structure (106'), of the stack (102) has a higher thermal conductivity compared to at least one remaining electrically insulating layer structure (106) of the stack (102);
wherein said blocks (112, 114, 116, 118) are at least partially electrically conductive;
comprising at least one vertical hole (120) extending through at least part of the stack (102) and connecting, in particular electrically connecting, at least two of said blocks (112, 114, 116, 118), in particular embodied as copper blocks, with each other;
wherein a current path (136) being configured for high power applications, in particular for an electric voltage transport of at least 20 kV, is established through the first electronic component (108) and the second electronic component (110).

12. A component carrier (100) according to any of claims 1 to 11, comprising:
a vertical hole (120) extending through at least part of the stack (102) and through the entire block (112), wherein the block (112) has a nail head structure (122), formed by a ductile deformation of the block (112), surrounding at least part of the vertical hole (120) and protruding downwardly beyond a planar portion (124) of a lower main surface of the block (112) and protruding upwardly beyond a planar portion (126) of an upper main surface of the block (112); and
a contact structure (140) in at least part of the vertical hole (120) forming a connection with the block (112) along the nail head section (122).

13. The component carrier (100) according to claim 12, comprising at least one of the following features:
wherein the contact structure (140) is an electrically conductive contact structure (140) forming an electrically conductive connection with the block (112) along the nail head section (122);
wherein the contact structure (140) comprises one of the group consisting of a plated metal structure, and a pin pressed into the vertical hole (120);
wherein the nail head structure (122) protrudes upwardly and/or downwardly beyond the respective planar portion (124, 126) by a value in a range from 5 µm to 70 µm, in particular by a value in a range from 50 µm to 70 µm;
wherein the block (112) comprises a metal coated ceramic, or consists of a metal, in particular copper.

14. A method of manufacturing a component carrier (100), wherein the method comprises:
providing a stack (102) comprising a plurality of electrically conductive layer structures (104) and a plurality of electrically insulating layer structures (106); laminating a first electronic component (108) and a second electronic component (110) in the stack (102); arranging a first block (112) and a second block (114) in the stack (102) below the first electronic component (108) and the second electronic component (110); and arranging a third block (116) and a fourth block (118) in the stack (102) above the first electronic component (108) and the second electronic component (110); electrically and thermally coupling each of said blocks (112, 114, 116, 118) with at least one of the first electronic component (108) and the second electronic component (110); wherein said blocks (112, 114, 116, 118) are thermally conductive, wherein said stack (102) comprises a first core (130) within which the first electronic component (108) and the second electronic component (110) are arranged, a second core (132) within which the first block (112) and the second block (114) are arranged, and a third core (134) within which the third block (116) and the fourth block (118) are arranged, each of said second core (132) and third core (134) comprises a centrally electrically insulating layer structure (106) covered on each of the two opposing surfaces with a respective electrically conductive layer structure (104), said first electronic component (108) and a second electronic component (110) being connected to one to said electrically conductive layer structures (104) of each said second core (132) and third core (134) through a respective connection medium (144).

## Patentansprüche

1. Ein Komponententräger (100), wobei der Komponententräger (100) aufweist:
einen Stapel (102) aufweisend eine Mehrzahl von elektrisch leitfähigen Schichtstrukturen (104) und eine Mehrzahl von elektrisch isolierenden Schichtstrukturen (106);
eine erste elektronische Komponente (108) und eine zweite elektronische Komponente (110), die in dem Stapel (102) laminiert sind;
einen ersten Block (112) und einen zweiten Block (114), die in dem Stapel (102) unter der ersten elektronischen Komponente (108) und der zweiten elektronischen Komponente (110) angeordnet sind; und
einen dritten Block (116) und einen vierten Block (118), die in dem Stapel (102) über der ersten elektronischen Komponente (108) und der zweiten elektronischen Komponente (110) angeordnet sind,
wobei die Blöcke (112, 114, 116, 118) thermisch leitfähig sind, und
wobei jeder der Blöcke (112, 114, 116, 118) elektrisch und thermisch mit zumindest einer der ersten elektronischen Komponente (108) und der zweiten elektronischen Komponente (110) gekoppelt ist,
wobei der Stapel (102) einen ersten Kern (130), innerhalb dessen die erste elektronische Komponente (108) und die zweite elektronische Komponente (110) angeordnet sind, einen zweiten Kern (132), innerhalb dessen der erste Block (112) und der zweite Block (114) angeordnet sind, und einen dritten Kern (134) aufweist, innerhalb dessen der dritte Block (116) und der vierte Block (118) angeordnet sind, wobei jeder des zweiten Kerns (132) und des dritten Kerns (134) eine zentral elektrisch isolierende Schichtstruktur (106) aufweist, die auf jeder der zwei gegenüberliegenden Oberflächen mit einer jeweiligen elektrisch leitfähigen Schichtstruktur (104) bedeckt ist, wobei die erste elektronische Komponente (108) und eine zweite elektronische Komponente (110) mit einer der elektrisch leitfähigen Schichtstrukturen (104) von jedem des zweiten Kerns (132) und des dritten Kerns (134) durch ein jeweiliges Verbindungsmedium (144) verbunden sind.

2. Der Komponententräger (100) gemäß Anspruch 1, wobei jede der ersten elektronischen Komponente (108) und der zweiten elektronischen Komponente (110) ein Halbleiterchip ist, insbesondere zumindest einer von einem Halbleiterleistungschip und einem Transistorchip.

3. Der Komponententräger (100) gemäß Anspruch 1 oder 2, wobei der Stapel (102) nur laminierte Schichtstrukturen (104, 106) aufweist.

4. Der Komponententräger (100) gemäß einem der Ansprüche 1 bis 3,
wobei zumindest einer der Blöcke (112, 114, 116, 118) eines aus der Gruppe aufweist, die aus einem Metallblock, insbesondere einem Kupferblock, einem Keramikblock (112a, 114a), der mit einer elektrisch leitfähigen Schicht (112b, 114b) auf zumindest einer von zwei gegenüberliegenden Hauptoberflächen des Keramikblocks (112a, 114a) bedeckt ist, und einem reinen Keramikblock besteht.

5. Der Komponententräger (100) gemäß einem der Ansprüche 1 bis 4,
wobei die erste elektronische Komponente (108) und die zweite elektronische Komponente (110) mit einem vertikalen Stromfluss zwischen gegenüberliegenden Hauptoberflächen davon arbeiten.

6. Der Komponententräger (100) gemäß einem der Ansprüche 1 bis 5, aufweisend einen kontinuierlichen elektrisch leitfähigen Pfad (136), der die zumindest eine elektrisch leitfähige Schichtstruktur (104), die Blöcke (112, 114, 116, 118), die erste elektronische Komponente (108) und die zweite elektronische Komponente (110) beinhaltet.

7. Der Komponententräger (100) gemäß einem der Ansprüche 1 bis 6, aufweisend zumindest ein vertikales Loch (120), das sich durch zumindest einen Teil des Stapels (102) erstreckt und sich vollständig durch zumindest einen der Blöcke (112, 114, 116, 118) erstreckt, wobei das zumindest eine vertikale Loch (120) zumindest teilweise mit einer elektrisch leitfähigen Struktur (140) gefüllt ist.

8. Der Komponententräger (100) gemäß den Ansprüchen 6 und 7, wobei der kontinuierliche elektrisch leitfähige Pfad (136) die elektrisch leitfähige Struktur (140) in dem zumindest einen vertikalen Loch (120) beinhaltet.

9. Der Komponententräger (100) gemäß einem der Ansprüche 1 bis 8, aufweisend zumindest eines der folgenden Merkmale:
wobei das Verbindungsmedium (144) eines aus der Gruppe aufweist, die aus einer Sinterstruktur, insbesondere einer Silbersinterstruktur, einer Lötstruktur, insbesondere einer Diffusionslötstruktur, und einem Klebstoff, insbesondere einem elektrisch leitfähigen Klebstoff, besteht;
wobei die Blöcke (112, 114, 116, 118) konfiguriert sind, um Elektrizität zwischen der ersten elektronischen Komponente (108) und der zweiten elektronischen Komponente (110) zu leiten, und konfiguriert sind, um Wärme von einer zugeordneten der ersten elektronischen Komponente (108) und der zweiten elektronischen Komponente (110) in Richtung der oberen Hauptoberfläche und der unteren Hauptoberfläche des Komponententrägers (100) abzuführen.

10. Der Komponententräger (100) gemäß einem der Ansprüche 1 bis 9, aufweisend zumindest eines der folgenden Merkmale:
wobei in einer Querschnittsansicht des Komponententrägers (100) ein Strompfad (136) eingerichtet ist, der eine horizontale Sektion (148), eine nachfolgende vertikale Sektion (150), die sich durch die erste elektronische Komponente (108) erstreckt, eine nachfolgende horizontale Sektion (152), eine nachfolgende vertikale Sektion (154), die sich zwischen der ersten elektronischen Komponente (108) und der zweiten elektronischen Komponente (110) erstreckt, eine nachfolgende horizontale Sektion (156), eine nachfolgende vertikale Sektion (158), die sich durch die zweite elektronische Komponente (110) erstreckt, und eine nachfolgende horizontale Sektion (160) hat;
wobei die erste elektronische Komponente (108) und die zweite elektronische Komponente (110) konfiguriert sind und durch die Blöcke (112, 114, 116, 118) und die zumindest eine elektrisch leitfähige Schichtstruktur (104) miteinander verbunden sind, um eine Halbbrückenfunktion bereitzustellen.

11. Der Komponententräger (100) gemäß einem der Ansprüche 1 bis 10, aufweisend zumindest eines der folgenden Merkmale:
wobei der Stapel (102) eine Mehrzahl von elektrisch isolierenden Schichtstrukturen (106, 106') aufweist, und wobei zumindest eine elektrisch isolierende Schichtstruktur (106'), insbesondere eine oberste und/oder eine unterste elektrisch isolierende Schichtstruktur (106'), des Stapels (102) eine höhere thermische Leitfähigkeit im Vergleich zu zumindest einer verbleibenden elektrisch isolierenden Schichtstruktur (106) des Stapels (102) hat;
wobei die Blöcke (112, 114, 116, 118) zumindest teilweise elektrisch leitfähig sind;
aufweisend zumindest ein vertikales Loch (120), das sich durch zumindest einen Teil des Stapels (102) erstreckt und zumindest zwei der Blöcke (112, 114, 116, 118), die insbesondere als Kupferblöcke verkörpert sind, miteinander verbindet, insbesondere elektrisch verbindet;
wobei ein Strompfad (136), der für Hochleistungsanwendungen konfiguriert ist, insbesondere für einen elektrischen Spannungstransport von zumindest 20 kV, durch die erste elektronische Komponente (108) und die zweite elektronische Komponente (110) eingerichtet ist.

12. Ein Komponententräger (100) gemäß einem der Ansprüche 1 bis 11, aufweisend:
ein vertikales Loch (120), das sich durch zumindest einen Teil des Stapels (102) und durch den gesamten Block (112) erstreckt, wobei der Block (112) eine Nagelkopfstruktur (122) hat, die durch eine duktile Verformung des Blocks (112) gebildet ist, zumindest einen Teil des vertikalen Lochs (120) umgibt und nach unten über einen planaren Abschnitt (124) einer unteren Hauptoberfläche des Blocks (112) hinausragt und nach oben über einen planaren Abschnitt (126) einer oberen Hauptoberfläche des Blocks (112) hinausragt; und
eine Kontaktstruktur (140) in zumindest einem Teil des vertikalen Lochs (120), die eine Verbindung mit dem Block (112) entlang der Nagelkopfsektion (122) bildet.

13. Der Komponententräger (100) gemäß Anspruch 12, aufweisend zumindest eines der folgenden Merkmale:
wobei die Kontaktstruktur (140) eine elektrisch leitfähige Kontaktstruktur (140) ist, die eine elektrisch leitfähige Verbindung mit dem Block (112) entlang der Nagelkopfsektion (122) bildet;
wobei die Kontaktstruktur (140) eines aus der Gruppe aufweist, die aus einer plattierten Metallstruktur und einem Stift, der in das vertikale Loch (120) gepresst ist, besteht;
wobei die Nagelkopfstruktur (122) nach oben und/oder nach unten über den jeweiligen planaren Abschnitt (124, 126) um einen Wert in einem Bereich von 5 µm bis 70 µm, insbesondere um einen Wert in einem Bereich von 50 µm bis 70 µm, hinausragt;
wobei der Block (112) eine metallbeschichtete Keramik aufweist oder aus einem Metall, insbesondere Kupfer, besteht.

14. Ein Verfahren zum Herstellen eines Komponententrägers (100), wobei das Verfahren aufweist:
Bereitstellen eines Stapels (102) aufweisend eine Mehrzahl von elektrisch leitfähigen Schichtstrukturen (104) und eine Mehrzahl von elektrisch isolierenden Schichtstrukturen (106);
Laminieren einer ersten elektronischen Komponente (108) und einer zweiten elektronischen Komponente (110) in dem Stapel (102);
Anordnen eines ersten Blocks (112) und eines zweiten Blocks (114) in dem Stapel (102) unter der ersten elektronischen Komponente (108) und der zweiten elektronischen Komponente (110); und
Anordnen eines dritten Blocks (116) und eines vierten Blocks (118) in dem Stapel (102) über der ersten elektronischen Komponente (108) und der zweiten elektronischen Komponente (110);
elektrisches und thermisches Koppeln jedes der Blöcke (112, 114, 116, 118) mit zumindest einer der ersten elektronischen Komponente (108) und der zweiten elektronischen Komponente (110);
wobei die Blöcke (112, 114, 116, 118) thermisch leitfähig sind,
wobei der Stapel (102) einen ersten Kern (130), innerhalb dessen die erste elektronische Komponente (108) und die zweite elektronische Komponente (110) angeordnet sind, einen zweiten Kern (132), innerhalb dessen der erste Block (112) und der zweite Block (114) angeordnet sind, und einen dritten Kern (134) aufweist, innerhalb dessen der dritte Block (116) und der vierte Block (118) angeordnet sind, wobei jeder des zweiten Kerns (132) und des dritten Kerns (134) eine zentral elektrisch isolierende Schichtstruktur (106) aufweist, die auf jeder der zwei gegenüberliegenden Oberflächen mit einer jeweiligen elektrisch leitfähigen Schichtstruktur (104) bedeckt ist, wobei die erste elektronische Komponente (108) und eine zweite elektronische Komponente (110) mit einer der elektrisch leitfähigen Schichtstrukturen (104) von jedem des zweiten Kerns (132) und des dritten Kerns (134) durch ein jeweiliges Verbindungsmedium (144) verbunden sind.

## Revendications

1. Support de composant (100), dans lequel le support de composant (100) comprend :
un empilement (102) comprenant une pluralité de structures de couche électroconductrice (104) et une pluralité de structures de couche électriquement isolante (106) ;
un premier composant électronique (108) et un second composant électronique (110) stratifiés dans l'empilement (102) ;
un premier bloc (112) et un deuxième bloc (114) agencés dans l'empilement (102) en dessous du premier composant électronique (108) et du second composant électronique (110) ; et
un troisième bloc (116) et un quatrième bloc (118) agencés dans l'empilement (102) au-dessus du premier composant électronique (108) et du second composant électronique (110),
dans lequel lesdits blocs (112, 114, 116, 118) sont thermoconducteurs, et dans lequel chacun desdits blocs (112, 114, 116, 118) est couplé électriquement et thermiquement à au moins l'un du premier composant électronique (108) et du second composant électronique (110),
dans lequel ledit empilement (102) comprend un premier noyau (130) à l'intérieur duquel le premier composant électronique (108) et le second composant électronique (110) sont agencés, un deuxième noyau (132) à l'intérieur duquel le premier bloc (112) et le deuxième bloc (114) sont agencés, et un troisième noyau (134) à l'intérieur duquel le troisième bloc (116) et le quatrième bloc (118) sont agencés, chacun desdits deuxième noyau (132) et troisième noyau (134) comprend une structure de couche électriquement isolante centrale (106) recouverte sur chacune des deux surfaces opposées d'une structure de couche électroconductrice respective (104), ledit premier composant électronique (108) et un second composant électronique (110) étant connectés à l'une desdites structures de couche électroconductrice (104) de chacun desdits deuxième noyau (132) et troisième noyau (134) par l'intermédiaire d'un support de connexion respectif (144).

2. Support de composant (100) selon la revendication 1, dans lequel chacun du premier composant électronique (108) et du second composant électronique (110) est une puce semi-conductrice, en particulier au moins l'une d'une puce de puissance semi-conductrice et d'une puce de transistor.

3. Support de composant (100) selon la revendication 1 ou 2, dans lequel l'empilement (102) comprend uniquement des structures de couche stratifiées (104, 106).

4. Support de composant (100) selon l'une quelconque des revendications 1 à 3, dans lequel au moins l'un desdits blocs (112, 114, 116, 118) comprend l'un du groupe constitué d'un bloc métallique, en particulier un bloc de cuivre, d'un bloc de céramique (112a, 114a) recouvert d'une couche électroconductrice (112b, 114b) sur au moins l'une des deux surfaces principales opposées du bloc de céramique (112a, 114a), et d'un bloc de céramique pure.

5. Support de composant (100) selon l'une quelconque des revendications 1 à 4, dans lequel le premier composant électronique (108) et le second composant électronique (110) fonctionnent avec un flux de courant vertical entre leurs surfaces principales opposées.

6. Support de composant (100) selon l'une quelconque des revendications 1 à 5, comprenant un trajet électroconducteur continu (136) qui comprend la au moins une structure de couche électroconductrice (104), lesdits blocs (112, 114, 116, 118), le premier composant électronique (108) et le deuxième composant électronique (110).

7. Support de composant (100) selon l'une quelconque des revendications 1 à 6, comprenant au moins un trou vertical (120) s'étendant à travers au moins une partie de l'empilement (102) et s'étendant entièrement à travers au moins l'un desdits blocs (112, 114, 116, 118), dans lequel le au moins un trou vertical (120) est au moins partiellement rempli d'une structure électroconductrice (140) .

8. Support de composant (100) selon les revendications 6 et 7, dans lequel le trajet électroconducteur continu (136) comprend la structure électroconductrice (140) dans ledit au moins un trou vertical (120).

9. Support de composant (100) selon l'une quelconque des revendications 1 à 8, comprenant au moins l'une des caractéristiques suivantes :
dans lequel le support de connexion (144) comprend l'un du groupe constitué d'une structure frittée, en particulier d'une structure frittée en argent, d'une structure de soudure, en particulier d'une structure de soudure par diffusion, et d'un adhésif, en particulier d'un adhésif électroconducteur ;
dans lequel lesdits blocs (112, 114, 116, 118) sont configurés pour conduire de l'électricité entre le premier composant électronique (108) et le second composant électronique (110) et sont configurés pour évacuer de la chaleur à partir d'un assigné du premier composant électronique (108) et du second composant électronique (110) vers la surface principale supérieure et la surface principale inférieure du support de composant (100).

10. Support de composant (100) selon l'une quelconque des revendications 1 à 9, comprenant au moins l'une des caractéristiques suivantes :
dans lequel, dans une vue en section transversale du support de composant (100), un trajet de courant (136) est établi, qui présente une section horizontale (148), une section verticale ultérieure (150) s'étendant à travers le premier composant électronique (108), une section horizontale ultérieure (152), une section verticale ultérieure (154) s'étendant entre le premier composant électronique (108) et le second composant électronique (110), une section horizontale ultérieure (156), une section verticale ultérieure (158) s'étendant à travers le second composant électronique (110), et une section horizontale ultérieure (160) ;
dans lequel le premier composant électronique (108) et le second composant électronique (110) sont configurés et sont interconnectés par les blocs (112, 114, 116, 118) et la au moins une structure de couche électroconductrice (104) pour fournir une fonction en demi-pont.

11. Support de composant (100) selon l'une quelconque des revendications 1 à 10, comprenant au moins l'une des caractéristiques suivantes :
dans lequel l'empilement (102) comprend une pluralité de structures de couche électriquement isolante (106, 106'), et dans lequel au moins une structure de couche électriquement isolante (106'), en particulier une structure de couche électriquement isolante supérieure et/ou inférieure (106'), de l'empilement (102) présente une conductivité thermique plus élevée par comparaison à au moins une structure de couche électriquement isolante restante (106) de l'empilement (102) ;
dans lequel lesdits blocs (112, 114, 116, 118) sont au moins partiellement électroconducteurs ;
comprenant au moins un trou vertical (120) s'étendant à travers au moins une partie de l'empilement (102) et connectant, en particulier connectant électriquement, au moins deux desdits blocs (112, 114, 116, 118), en particulier réalisés sous forme de blocs de cuivre, l'un à l'autre ;
dans lequel un trajet de courant (136) étant configuré pour des applications de haute puissance, en particulier pour un transport de tension électrique d'au moins 20 kV, est établi à travers le premier composant électronique (108) et le second composant électronique (110).

12. Support de composant (100) selon l'une quelconque des revendications 1 à 11, comprenant :
un trou vertical (120) s'étendant à travers au moins une partie de l'empilement (102) et à travers l'ensemble du bloc (112), dans lequel le bloc (112) présente une structure de tête de clou (122), formée par une déformation ductile du bloc (112), entourant au moins une partie du trou vertical (120) et faisant saillie vers le bas au-delà d'une partie plane (124) d'une surface principale inférieure du bloc (112) et faisant saillie vers le haut au-delà d'une partie plane (126) d'une surface principale supérieure du bloc (112) ; et
une structure de contact (140) dans au moins une partie du trou vertical (120) formant une connexion avec le bloc (112) le long de la section de tête de clou (122).

13. Support de composant (100) selon la revendication 12, comprenant au moins l'une des caractéristiques suivantes :
dans lequel la structure de contact (140) est une structure de contact électroconductrice (140) formant une connexion électroconductrice avec le bloc (112) le long de la section de tête de clou (122) ;
dans lequel la structure de contact (140) comprend l'une du groupe constitué d'une structure métallique plaquée, et d'une broche pressée dans le trou vertical (120) ;
dans lequel la structure de tête de clou (122) fait saillie vers le haut et/ou vers le bas au-delà de la partie plane respective (124, 126) d'une valeur comprise entre 5 µm et 70 µm, en particulier d'une valeur comprise entre 50 µm et 70 um ;
dans lequel le bloc (112) comprend une céramique revêtue de métal, ou est constitué d'un métal, en particulier de cuivre.

14. Procédé de fabrication d'un support de composant (100), dans lequel le procédé comprend les étapes consistant à :
fournir un empilement (102) comprenant une pluralité de structures de couche électroconductrice (104) et une pluralité de structures de couche électriquement isolante (106) ;
stratifier un premier composant électronique (108) et un second composant électronique (110) dans l'empilement (102) ;
agencer un premier bloc (112) et un deuxième bloc (114) dans l'empilement (102) en dessous du premier composant électronique (108) et du second composant électronique (110) ; et
agencer un troisième bloc (116) et un quatrième bloc (118) dans l'empilement (102) au-dessus du premier composant électronique (108) et du second composant électronique (110) ;
coupler électriquement et thermiquement chacun desdits blocs (112, 114, 116, 118) à au moins l'un du premier composant électronique (108) et du second composant électronique (110) ;
dans lequel lesdits blocs (112, 114, 116, 118) sont thermoconducteurs, dans lequel ledit empilement (102) comprend un premier noyau (130) à l'intérieur duquel le premier composant électronique (108) et le second composant électronique (110) sont agencés, un second noyau (132) à l'intérieur duquel le premier bloc (112) et le deuxième bloc (114) sont agencés, et un troisième noyau (134) à l'intérieur duquel le troisième bloc (116) et le quatrième bloc (118) sont agencés, chacun dudit deuxième noyau (132) et du troisième noyau (134) comprend une structure de couche électriquement isolante centrale (106) recouverte sur chacune des deux surfaces opposées d'une structure de couche électroconductrice respective (104), ledit premier composant électronique (108) et un second composant électronique (110) étant connectés à l'une desdites structures de couche électroconductrice (104) de chacun desdits deuxième noyau (132) et troisième noyau (134) par l'intermédiaire d'un support de connexion respectif (144).
